Europäisches Patentamt

European Patent Office

Office européen des brevets

(19)

(11) Numéro de publication : **0 424 263 B1**

(12) **FASCICULE DE BREVET EUROPEEN**

(45) Date de publication du fascicule du brevet :
05.08.92 Bulletin 92/32

(51) Int. Cl.⁵ : **G06K 7/00**

(21) Numéro de dépôt : **90402932.9**

(22) Date de dépôt : **18.10.90**

(54) **Système de carte à puce munie d'une électronique portable déportée.**

(30) Priorité : **20.10.89 FR 8913756**

(43) Date de publication de la demande :
**24.04.91 Bulletin 91/17**

(45) Mention de la délivrance du brevet :
**05.08.92 Bulletin 92/32**

(84) Etats contractants désignés :
**DE GB IT**

(56) Documents cités :
**US-A- 4 277 837**

(73) Titulaire : **SGS-THOMSON MICROELECTRONICS S.A.
7, Avenue Galliéni
F-94250 Gentilly (FR)**

(72) Inventeur : **Steffen, Francis
Cabinet BALLOT-SCHMIT 7, rue Le Sueur
F-75116 Paris (FR)**

(74) Mandataire : **Schmit, Christian Norbert Marie et al
Cabinet Ballot-Schmit 7, rue Le Sueur
F-75116 Paris (FR)**

Jouve, 18, rue Saint-Denis, 75001 PARIS

# Description

La présente invention concerne un système de carte à puce munie d'une électronique portable déportée. Ce système est utilisable dans le domaine des cartes à puces.

Les applications diverses nouvelles de la carte à puce montrent que cette est appelée à réaliser des fonctions de plus en plus complexes, si on veut étendre son domaine d'applications. Ceci conduit alors à la nécessité d'utiliser des surfaces de puces à intégrer dans ces cartes de plus en plus importantes, pour réaliser ces fonctions. Tel est le cas par exemple, des deux applications connues de la carte à puce que sont la carte téléphone et la carte bancaire. La puce de la carte téléphone est une simple mémoire. Elle occupe une surface de l'ordre du mm². La puce d'une carte bancaire est un processeur intégrant de la mémoire. Elle occupe une surface de l'ordre de 20mm². Ceci s'entend pour un état de la technique d'intégration de semi-conducteurs donné. Chacun sait, en effet, que l'on continue de progresser dans le domaine de l'intégration de semi-conducteurs. C'est à dire que pour une même taille de circuit intégré, on arrivera à intégrer de plus en plus de fonctions.

Rappelons brièvement qu'une carte à puce est une carte plastique relativement peu épaisse, dans laquelle sont encartées, dans l'épaisseur de la carte, une puce de semi-conducteur et une grille de conducteurs. La puce est assemblée à une surface supérieure de la grille, par exemple par collage. Des fils conducteurs sont ensuite soudés d'une part sur des bornes de sorties de la puce, d'autre part, sur des métallisations de la grille. C'est la technologie d'assemblage de la carte à puce, dite de chip on board, dans la littérature anglo-saxonne. Une surface inférieure de la grille affleure l'une des deux surfaces de la carte et constitue le connecteur de la carte à puce. Quand cette carte est insérée dans le lecteur, c'est sur ce connecteur que vient se brancher le lecteur.

Les lecteurs standards, tels ceux des publiphones est des systèmes bancaires, ont imposé une normalisation des cartes à puces. On distingue tout d'abord une normalisation de la carte elle-même en tant qu'objet. Cette normalisation de la forme et de l'épaisseur a été imposée par l'antécédence des cartes magnétiques, dans le but d'utiliser les lecteurs des cartes magnétiques déjà existants. On distingue ensuite une normalisation du connecteur, portant sur la forme, le nombre, le pas de connectique des zones de contact du connecteur et sur l'attribution d'une signal déterminé sur chaque zone de contact, conformément à un protocole de communication. On distingue enfin, une normalisation de la position relative du connecteur sur la carte. Une normalisation française impose une position du connecteur dans un coin de la carte. Une normalisation allemande impose une position du connecteur au milieu.

La normalisation du connecteur impose en particulier une distribution déterminée des zones de contact du connecteur qui imposent une utilisation de surface libre non extensible. Cette surface limite la surface possible de la puce qu'on veut assembler sur ce connecteur avec la technologie d'assemblage de la carte à puce. En effet, la largeur de la puce doit être entièrement comprise dans celle occupée par le connecteur.

A cette première limitation technologique de la surface de la puce intégrable dans une carte à puce, il s'en rajoute une seconde. En effet, le support classique de la carte à puce est mal adapté à une puce de grande surface. Si ce support est souple, la puce, elle, est très rigide. Plus la puce est grande, plus elle est sensible aux déformations et plus on a de chances de l'abîmer. Ce qui a pour effet, en pratique, de diminuer la fiabilité de la carte à puce, quand celle-ci intègre une grande puce. Ceci n'est pas tolérable vis-à-vis des applications de la carte à puce, notamment vis-à-vis des applications bancaires.

Diverses techniques connues ont été utilisées pour remédier à ce problème. On a notamment essayé de diminuer l'amplitude des déformations au niveau de la puce et des fils qui la relient à sa grille de connecteurs. On peut citer, par exemple, l'utilisation connue d'une dalle de cobalt placée sous le substrat de la puce, pour rigidifier la puce. Dans un autre exemple, on a modifié le procédé de réalisation d'une cavité dans la carte pour recevoir la puce afin de rigidifier l'environnement de la puce. Mais ces solutions ne permettent pourtant pas d'assembler, dans cette technologie d'assemblage de la carte à puce, des surfaces importantes : supérieures à 20mm² par exemple. Et pour de telles surfaces, nombre de problèmes apparaissent, notamment celui de la fiabilité de la puce ainsi assemblée.

Par ailleurs, le matériau plastique qui constitue la carte n'est pas étanche aux diverses pollutions ioniques et organiques auxquelles sont très sensibles les puces de circuit intégré. La détérioration de la fiabilité induite est d'autant plus aggravée que la puce est grande. Ceci est une troisième limitation technologique.

La technologie d'assemblage utilisée est enfin du type hybride. Elle n'est pas optimisée en terme de production. En effet, dans le cadre de l'assemblage de semi-conducteurs, on utilise une ligne standard d'un produit qui est fait en très gros volume. Ce produit est une ou plusieurs puces assemblées dans un boîtier standard et appelé un composant électronique. A côté de ces composants électroniques produits en gros volume, on a donc un produit spécifique : par exemple, la puce assemblée sur une grille de conducteur pour la carte à puce.

Ce produit spécifique est produit dans un bien moins gros volume. Mais il nécessite une ligne de production spécifique, elle aussi. Ce qui augmente considérablement les coûts de production et les frais d'amortissement de cette ligne, par rapport aux lignes de production de produits standards. De plus, le taux de rejet de ce produit spécifique est beaucoup plus élevé que celui des produits standards du fait de la technologie utilisée. En effet, la fixation des fils conducteurs est une opération délicate, dont la fiabilité influe directement sur le produit final. Une protection spécifique de ces fils est nécessaire pour en garantir la non dégradation. Pour éviter ces difficultés, on a par ailleurs tenté, dans une technologie dite de "tape automatic bonding" de relier en particulier par transfert à chaud, des queues des métallisations de la grille, aux bornes de la puce. Cependant cette technologie souffre aussi de la précision de fabrication qu'elle nécessite. Elle ne conduit pas non plus à une fiabilité d'assemblage suffisante.

L'invention a pour objet de remédier à ces inconvénients et de permettre l'évolution de la carte à puce vers des applications nouvelles plus complexes. Elle utilise la carte à puce comme moyen intermédiaire.

Le document US-A-4 277,837 décrit un système de connexion d'un module électronique portable qui comporte les caractéristiques du préambule des revendications 1 ou 5.

L'invention a donc pour objet un système de connexion d'un module électronique portable, ce module comportant au moins un composant électronique, ce système comportant un lecteur pour entrer en relation avec ce module, un moyen intermédiaire en relation directe avec ce lecteur, et un moyen de transport d'informations en relation directe avec ce module, ce moyen de transport d'informations étant électriquement relié au moyen intermédiaire et servant d'assurer la transmission d'informations entre le moyen intermédiaire et le module et réciproquement caractérisé en ce que le module, le moyen de transport d'informations et le moyen intermédiaire sont physiquement liés, en ce que le moyen intermédiaire est une carte ayant la forme et les dimensions d'une carte à puce mais sans puce et munie d'un connecteur compatible avec le lecteur, et en ce que le moyen de transport est flexible.

Elle a aussi pour objet un système de connexion d'un module électronique portable, ce module comportant au moins un composant électronique, ce système comportant un lecteur pour entrer en relation avec ce module, un moyen intermédiaire en relation directe avec ce lecteur, et un moyen de transport d'informations en relation directe avec ce module, ce moyen de transport d'informations servant à assurer la transmission d'informations entre le moyen intermédiaire et le module et réciproquement, le moyen intermédiaire étant muni d'un émetteur récepteur pour communiquer avec le moyen de transport, et le moyen de transport comportant un émetteur récepteur pour communiquer avec le moyen intermédiaire, caractérisé en ce que le moyen intermédiaire est une carte ayant la forme et les dimensions d'une care à puce mais sans puce, et munie d'un connecteur compatible avec le lecteur.

Les caractéristiques d'un système conforme à l'invention sont données dans la description qui suit et qui est faite en référence aux figures annexées. Cette description et ces figures ne sont faites qu'à titre indicatif et non limitatif de l'invention. Dans ces figures :

– la figure 1 représente les différentes fonctions d'une système selon l'invention,

– la figure 2 est une vue représentative du module selon l'invention,

– la figure 3 est un ensemble de vues en coupe d'un moyen de transport réalisé par un ruban flexible,

– la figure 4 est une représentation d'un système selon l'invention.

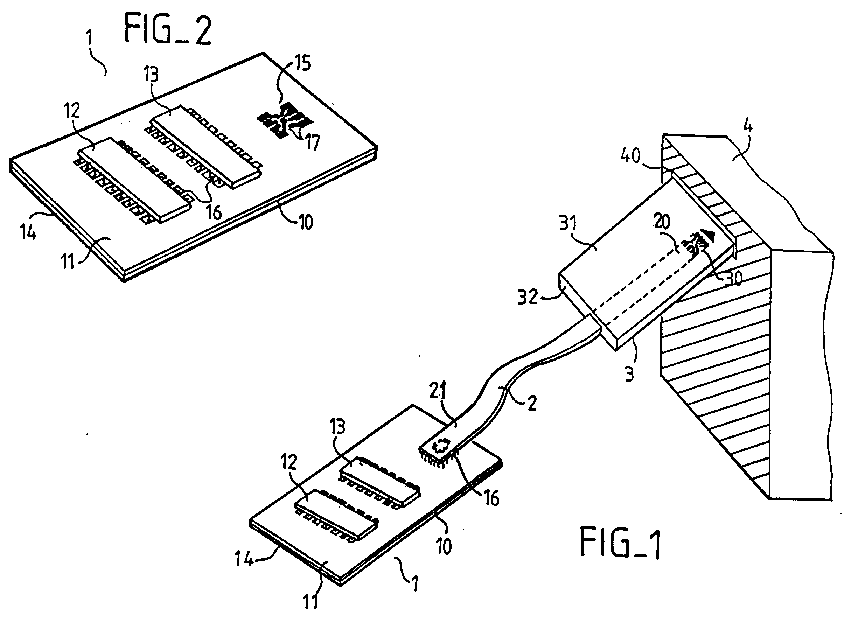

Dans la figure 1, on a un module 1, un moyen de transport 2, un moyen intermédiaire 3 et un lecteur 4. Le module 1 est alimenté à partir du lecteur 4, via le moyen intermédiaire 3 et le moyen de transport 2. Il comporte un support de connexion 10. Dans l'exemple des figures 1 et 2, ce support de connexion est une circuit imprimé multi-couches. Sur l'une de ses surfaces 11 sont montés un ou plusieurs composants électroniques. Par exemple, deux composants électroniques 12 et 13 sont montés sur la surface 11. Sur cette même surface 11, ou sur une surface opposée 14, affleure un connecteur 15. Dans l'exemple des figures 1 et 2, le connecteur 15 affleure à la surface 11. Le connecteur 15 relie des broches 16 des composants électroniques 12 et 13 aux sorties du module 1. Ces sorties du module sont les zones de contact extérieures 17 du connecteur 15. Elles affleurent à la surface 11. Elles sont reliées aux broches des composants électroniques par l'intérieur du connecteur.

Le moyen intermédiaire 3 s'insère en entier dans la fente 40 d'un lecteur 4. Le moyen intermédiaire 3 est par exemple une carte à puce, ou tout autre moyen pouvant être lu par un lecteur 4. Le lecteur 4 est partiellement représenté sur la figure 1. Quand le lecteur 4 communique avec la carte à puce 3, il se branche sur les zones de contact extérieures d'un connecteur 30 qui affleure une surface 31 de la carte à puce 3. Le connecteur 30 est conforme à la définition de la connexion avec le lecteur 4. La carte à puce peut intégrer un ou plusieurs connecteurs sur lesquels sont assemblées zéro ou plusieurs puces. Dans un exemple préféré, elle comporte un seul connecteur sur lequel aucune puce n'est assemblée. Cependant dans la suite, on continuera de l'appeler carte à puce. Dans l'exemple, toute l'électronique est réalisée dans le module 1 qui peut intégrer de multiples fonctions.

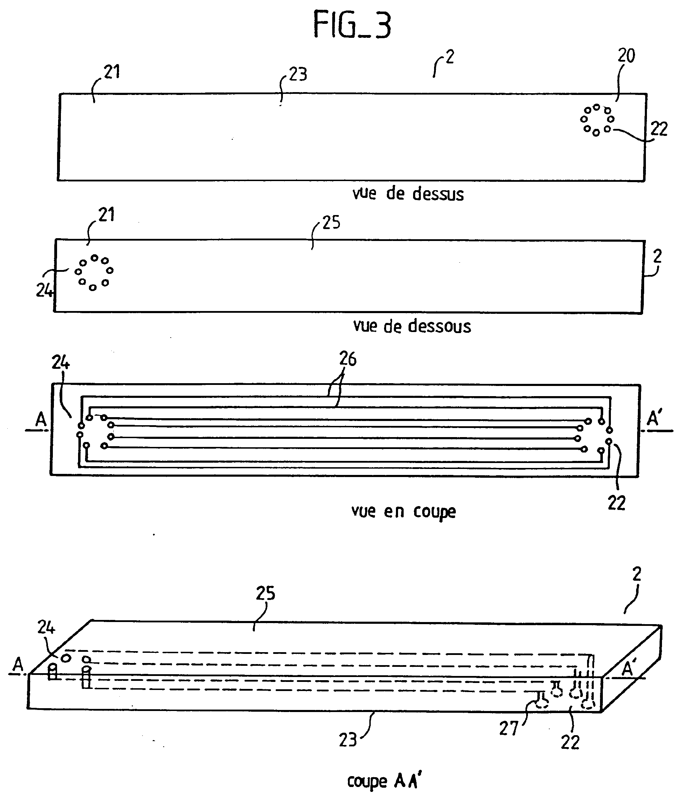

Le moyen de transport 2 est détaillé dans les différentes vues en coupe de la figure 3. Dans cette figure le moyen de transport comporte deux extrémités 20 et 21. A l'extrémité 20, un connecteur 22 affleure à une surface supérieure 23 du moyen de transport 2. Ce connecteur est compatible avec une inter-connexion avec le connecteur 30 de la carte à puce 3. A l'extrémité 21, un connecteur 24 affleure à une surface inférieure 25 du moyen de transport 2. Ce connecteur est compatible avec une inter-connexion avec le connecteur 15 du module 1. Dans un exemple préféré, le moyen de transport est un ruban flexible de matière isolante à l'intérieur et/ou sur lequel ont été gravées des zones de conduction : ces zones de conduction sont, dans l'exemple de la figure 3, les deux connecteurs 22 et 24 et des fils de conduction 26. Le fils de conduction sont gravés à l'intérieur du ruban. Les zones de contact du connecteur sont extérieures, c'est à dire qu'elles sont gravées sur une surface du ruban. Chaque fil de conduction relie une zone de contact du connecteur 22 à une zone de contact du connecteur 24. La liaison entre l'extrémité d'un fil et une zone de contact extérieure des connecteurs 22 ou 24 se fait par un trou métallisé 27 sous la zone de contact extérieure, entre la surface à laquelle affleure la zone de contact et le plan dans lequel sont gravés les fils de conduction.

L'extrémité 20 du moyen de transport 2 est fixée dans le moyen intermédiaire 3. Chaque zone de contact du connecteur 22 est en contact avec une zone de contact du connecteur 30. Le contact est fait par l'intérieur du connecteur 30. La fixation est réalisée par exemple par soudure entre le connecteur 22 et la partie intérieure du connecteur 30. Le moyen de transport est placé en sorte qu'il arrive sur la carte à puce 3 par le côté opposé 32 à celui par lequel on insère la carte à puce 3 dans la fente 40 du lecteur 4. Toute la partie du moyen de transport 2, au niveau du côté 32 jusqu'à l'extrémité 20, est prise dans le matériau d'enrobage de la carte à puce 3.

L'extrémité 21 du moyen de transport 2 est fixée à la surface 11 du module 1. La fixation est par exemple réalisée par une soudure 16. L'extrémité 21 est fixée de telle manière que chaque zone de contact du connecteur 24 est en contact avec une zone de contact du connecteur 15. Ici, le contact est fait sur les zones de contact extérieures du connector 15.

Dans l'exemple préféré, la partie superficielle du connecteur 15 du module 1 est identique à celle d'une carte à puce, et donc à la partie superficielle du connecteur 30 de la carte à puce 3. La partie superficielle des connecteurs 22 et 24 du moyen de transport 2 est identique à la partie intérieure d'un connecteur d'une carte à puce. Ainsi il est aisé d'assembler ensemble les connecteurs 15 et 24 et les connecteurs 30 et 22, puisqu'ils sont les parties normalisées extérieure (15 et 30) et intérieure (24 et 22) d'un connecteur d'une carte à puce.

En fait, il est également possible d'avoir un seul support sur lequel on a le connecteur 30 de la carte à puce et qui assure l'interconnexion de ce connecteur 30 avec une électronique déportée précédemment décrite. On sait en effet réaliser un même support avec plusieurs matériaux par exemple, du circuit imprimé et un flex, le flex étant alors une couche du circuit imprimé. Dans ces conditions, le support d'interconnexion est commun au module 1, au moyen de transport 2, et à la carte à puce 3. Il n'y a plus de soudure ou de fixation à réaliser pour assembler le module 1 au moyen de transport 2 et le moyen de transport 2 à la carte à puce 3.

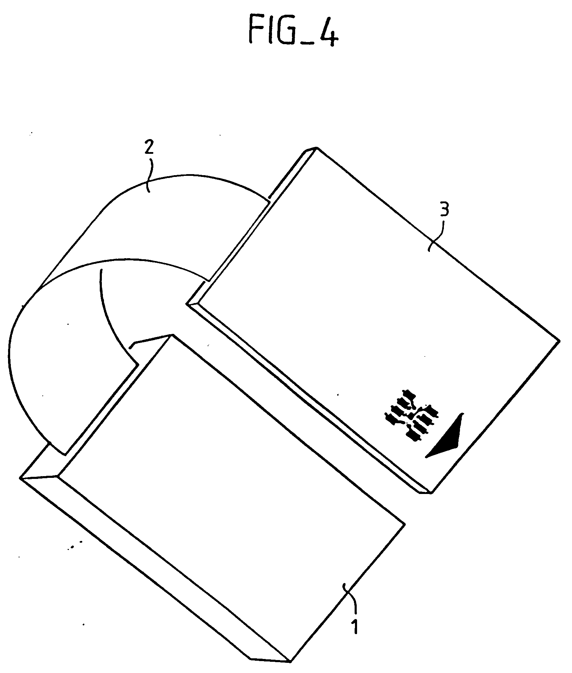

La figure 4 montre un module 1, un moyen de transport 2 et une carte à puce 3 conforme à la description qui vient d'être faite. Le module 1 est encarté dans un matériau qui est ou non diélectrique. S'il n'est pas diélectrique, on protégera les connexions métalliques des composants électroniques par un isolant. Comme le module comporte des composants électroniques, l'épaisseur de l'ensemble est plus grande que l'épaisseur d'une carte à puce, dans l'état de la technique actuelle des composants électroniques.

L'utilisation d'un ruban flexible permet de replier le module sur la carte à puce. L'ensemble se met alors facilement dans une poche. On pourrait utiliser un moyen de transport rigide, par exemple un circuit imprimé. Dans ce cas, on pourrait également enrober l'ensemble formé du module 1, du moyen de transport 2 et de la carte à puce 3. On aurait alors un produit relativement rigide et par exemple de forme rectangulaire, avec deux épaisseurs : celle plutôt petite de la carte à puce (0,8mm environ) et celle plus grande du module (à partir de 1,5mm).

Dans l'exemple de la figure 1, dans la connexion entre le connecteur 15 et le connecteur 30, seul le connecteur 30 est non protégé, pour que le lecteur vienne se brancher dessus. Tout le reste de cette connexion est par contre isolé, pour qu'aucune perturbation électrique ne se superpose aux signaux transmis.

Le transport des informations entre le moyen intermédiaire et le module peut se faire par un moyen de toute autre nature qu'un support d'inter-connexion comme un ruban flexible ou un circuit imprimé. Par exemple il peut se faire par transmission herzienne. Dans ce cas le moyen de transport comporte alors un émetteur et un récepteur avec une antenne dans le module 1 et dans la carte. Le module 1 et la carte à puce sont alors deux objets portables distincts. Pour des raisons de commodité, ils peuvent cependant être attachés l'un à l'autre, par un fil souple par exemple. Il faut cependant prévoir dans ce cas un amplificateur d'énergie intégré au module 1, si l'alimentation du module est transmise par voie herzienne à partir du lecteur 4 via la carte à puce 3. On peut préférer intégrer une pile rechargeable au module 1.

Dans le système que l'on vient de décrire, de multiples avantages apparaissent par rapport à la traditionnelle carte à puce. Et ceci parce que la partie électronique, le module 1, est dissociée de la partie connectique, la carte à puce 3. En effet, il permet tout d'abord de réaliser une électronique complexe, par l'assemblage d'un ou plusieurs composants électroniques inter-connectés ou non entre eux. Il n'y a plus de limitation de surface de l'électronique comme pour la carte à puce. De plus ces composants électroniques peuvent être eux-même complexes, intégrant par exemple dans leur boîtier plusieurs puces assemblées sur un circuit imprimé multi-couches.

On rappelle que le circuit imprimé multi-couches permet de réaliser d'une part des inter-connexions entre des éléments électroniques, puces ou composants, pour réaliser une fonction. D'autre part il permet de réaliser la connexion vers l'extérieur, c'est à dire les sorties de la fonction réalisée. Quand le circuit imprimé sur lequel sont assemblées plusieurs puces, est intégré dans un boîtier, les sorties de la fonction réalisée sont alors les broches du boîtier du composant électronique ainsi réalisé. Dans l'état actuel de la technologie d'assemblage de puces dans une carte à puce, il n'y a pas l'équivalent du circuit imprimé multi-couches.

Dans le système décrit, la fiabilité de l'electronique est considérablement améliorée par rapport à celle obtenue avec la technologie classique des cartes à puces. En effet un boîtier, par exemple plastique ou céramique, d'un composant électronique est rigide. Il est aussi étanche notamment aux diverses agressions ioniques et organiques. C'est lui qui améliore la fiabilité. De plus, le module lui-même peut être plus rigide que la carte à puce, puisque ce n'est pas lui qui est inséré dans le lecteur. En conclusion, dans l'invention, on a dès lors une fiabilité suffisante pour réaliser des applications complexes, en particulier bancaires. Ceci n'était pas envisageable avec la technologie classique de la carte à puce pour des raisons déjà expliquées.

Le choix d'une technologie d'assemblage des composants électroniques dans le module 1 est varié : ce peut être toute technologie standard, comme par exemple l'insertion ou le montage en surface. Dans l'exemple des figures 1 et 2, et sont des composants montés en surface. Ils permettent une plus grande densité d'intégration sur le circuit imprimé. Il est de plus possible d'assembler de tels composants sur chacune des deux surfaces du circuit imprimé. Ceci n'est pas possible avec une technologie d'insertion. Le choix du type de boîtier est aussi varié. Ce qui est important, c'est l'optimisation du coût de fabrication du module : en fonction de la densité d'intégration nécessaire pour l'application visée, du coût de fabrication et du taux de rejet dans chacune des diverses technologies.

L'aspect coût de fabrication est en effet très important dans le domaine des cartes à puces. L'objectif de prix d'achat des utilisateurs est an effet très faible. Pour cette raison, comme on l'a déjà vu, le coût de production et les frais d'amortissement induits par l'utilisation d'une chaîne de production spécifique dans la technologie classique des cartes à puces est un inconvénient majeur de cette technologie dans l'aspect coût de fabrication. A cela, s'ajoute le taux de rejet important, plus important que celui obtenu avec les technologies classiques de semi-conducteurs. L'utilisation des composants électroniques remédie à l'ensemble de ces inconvénients. En effet, les lignes de production sont alors les lignes standard d'assemblage de semi-conducteurs. De plus quand les composants électroniques sont assemblés sur le circuit imprimé, si le test final n'est pas bon, il est possible de dessouder un composant qui serait mauvais et de le remplacer par un autre. Il est possible de changer le circuit imprimé qui serait mauvais et de garder le composant : on ne perd pas l'ensemble du module. Ceci est un net avantage par rapport à la carte à puce : si elle n'est pas bonne, on ne peut rien récupérer.

Utiliser une carte à puce comme moyen intermédiaire résout le problème des normalisations et/ou des standards. C'est là tout son intérêt. Dans l'exemple préféré, la carte à puce comporte un connecteur normalisé compatible avec la connexion d'un lecteur : la carte à puce est un moyen intermédiaire standard de lecture directe par un lecteur. Sa fabrication est peu coûteuse car il n'y a pas d'assemblage de puces.

En résumé, l'invention permet donc de respecter les standards ou normalisations des lecteurs de cartes à puces, sans s'y laisser enfermer. Elle permet toutes les applications nouvelles complexes. Elle améliore considérablement la fiabilité de la partie électronique. Elle diminue les coûts de fabrication et les frais d'amortissement par une électronique de technologie standard dont seule l'application est spécifique, par rapport à la carte à puce classique dont l'électronique est spécifique et dans l'application et dans la technologie.

## Revendications

1. Système de connexion d'un module électronique portable (1), ce module comportant au moins un composant électronique, ce système comportant un lecteur (4) pour entrer en relation avec ce module, un moyen intermédiaire (3) en relation directe avec ce lecteur, et un moyen de transport d'informations (2) en relation directe avec ce module (1), ce moyen de transport d'informations (2) étant électriquement relié au moyen intermédiaire (3) et servant à assurer la transmission d'informations entre le moyen intermédiaire et le module et réciproquement caractérisé en ce que le module, le moyen de transport d'informations et le moyen intermédiaire sont physiquement liés, en ce que le moyen intermédiaire est une carte ayant la forme et les dimensions d'une carte à puce mais sans puce et munie d'un connecteur compatible avec le lecteur, et en ce que le moyen de transport est flexible.

2. Système selon la revendication 1, caractérisé en ce que des zones de conduction du module et du moyen de transport sont isolées électriquement de tout contact avec l'extérieur physique au système.

3. Système selon l'une quelconque des revendications 1 ou 2, caractérisé en ce que le moyen de transport comporte des moyens pour transporter également l'énergie nécessaire à alimenter le module, ce transport se faisant à partir du lecteur, via le moyen intermédiaire.

4. Système selon l'une quelconque des revendications 1 ou 2, caractérisé en ce que le module a un moyen d'alimentation intégré.

5. Système de connexion d'un module (1) électronique portable, ce module comportant au moins un composant électronique, ce système comportant un lecteur (4) pour entrer en relation avec ce module, un moyen intermédiaire (3) en relation directe avec ce lecteur, et un moyen de transport d'informations (2) en relation directe avec ce module, ce moyen de transport d'informations servant à assurer la transmission d'informations entre le moyen intermédiaire et le module et réciproquement, le moyen intermédiaire étant muni d'un émetteur récepteur pour communiquer avec le moyen de transport, et le moyen de transport comportant un émetteur récepteur pour communiquer avec le moyen intermédiaire, caractérisé en ce que le moyen intermédiaire est une carte ayant la forme et les dimensions d'une carte à puce mais sans puce, et munie d'un connecteur compatible avec le lecteur.

6. Système selon la revendication 5, caractérisé en ce que des zones de conduction du module et du moyen de transport sont isolées électriquement de tout contact avec l'extérieur physique au système.

7. Système selon l'une quelconque des revendications 5 ou 6, caractérisé en ce que le module a un moyen d'alimentation intégré.

**Patentansprüche**

1. Anschlußsystem für ein tragbares elektronisches Modul (1), wobei dieses Modul wenigstens ein elektronisches Bauteil umfaßt, wobei dieses System ein Lesegerät (4), um mit diesem Modul in Beziehung zu treten, ein Zwischenmittel (3) in direkter Beziehung mit diesem Lesegerät und ein Informationsübertragungsmittel (2) in direkter Beziehung mit diesem Modul (1) umfaßt, wobei dieses Informationsübertragungsmittel (2) elektrisch mit dem Zwischenmittel (3) verbunden ist und dazu dient, die Informationsübermittlung zwischen dem Zwischenmittel und dem Modul und umgekehrt sicherzustellen, dadurch gekennzeichnet, daß das Modul, das Informationsübertragungsmittel und das Zwischenmittel physisch verbunden sind, daß das Zwischenmittel eine Karte, die die Form und die Abmessungen einer Chipkarte aufweist, jedoch ohne Chip und mit einem mit dem Lesegerät kompatiblen Stecker versehen ist, und daß das Übertragungsmittel flexibel ist.

2. System nach Anspruch 1, dadurch gekennzeichnet, daß die Leitungszonen des Moduls und des Übertragungsmittels elektrisch von jeglichem Kontakt mit der physischen Außenseite zum System isoliert sind.

3. System nach einem beliebigen der Ansprüche 1 oder 2, dadurch gekennzeichnet, daß das Übertragungsmittel Mittel zum gleichen Übertragen von zur Versorgung des Moduls erforderlicher Energie umfaßt, wobei diese Übertragung ausgehend vom Lesegerät über das Zwischenmittel erfolgt.

4. System nach einem beliebigen der Ansprüche 1 oder 2, dadurch gekennzeichnet, daß das Modul ein integriertes Versorgungsmittel aufweist.

5. Anschlußsystem für ein tragbares elektronisches Modul (1), wobei dieses Modul wenigstens ein elektronisches Bauteil umfaßt, wobei dieses System ein Lesegerät (4), um mit diesem Modul in Beziehung zu treten, ein Zwischenmittel (3) in direkter Beziehung mit diesem Lesegerät und ein Informationsübertragungsmittel (2) in direkter Beziehung mit diesem Modul umfaßt, wobei dieses Informationsübertragungsmittel dazu dient, die Informationsübermittlung zwischen dem Zwischenmittel und dem Modul und umgekehrt sicherzustellen, wobei das Zwischenmittel mit einem Sender-Empfänger versehen ist, um mit dem Übertragungsmittel zu kommunizieren, und das Übertragungsmittel einen Sender-Empfänger umfaßt, um mit dem Zwischenmittel zu kommunizieren, dadurch gekennzeichnet, daß das Zwischenmittel eine Karte, die die Form und die Abmessungen einer Chipkarte aufweist, aber ohne Chip und mit einem mit dem Lesegerät kompatiblen Stecker versehen ist.

6. System nach Anspruch 5, daurch gekennzeichnet, daß die Leitungszonen des Moduls und des Übertragungsmittels elektrisch von jeglichem Kontakt mit der physischen Außenseite zum System isoliert sind.

7. System nach einem beliebigen der Ansprüche 5 oder 6, dadurch gekennzeichnet, daß das Modul ein integriertes Versorgungsmittel aufweist.

**Claims**

1. A connection system for a portable electronic module (1), the said module comprising at least one electronic component, the system comprising a reader (4) for interacting with this module, an intermediate means (3) interacting directly with said reader, and a means fortransmitting information (2) interacting directly with the said module (1), the means for transmitting information (2) being electrically connected to the intermediate means (3) and serving to provide the transmission of information between the intermediate means and the module and vice versa, characterized in that the module, the means for transmitting information and the intermediate means are physically connected, in that the intermediate means consist of a card having the shape and the dimensions of a smart card but without a processing chip and being equipped with a connector compatible with the reader, and in that the transmitting means are flexible.

2. A system as claimed in claim 1, characterized in that the conduction zones of the module and of the transmitting means are insulated electrically from any contact with the physical outside of the system.

3. A system as claimed in either one of claims 1 or 2, characterized in that the transmitting means also comprise means for transmitting the energy required to supply the module, this transmission occurring from the reader through the intermediate means.

4. A system as claimed in either one of claims 1 or 2, characterized in that the module comprises an integrated supply means.

5. A connection system for a portable electronic module (1), said module comprising at least one electronic component, the system comprising a reader (4) for interacting with this module, an intermediate means (3) interacting directly with said reader, and a means for transmitting information (2) interacting directly with said module, the means for transmitting information serving to provide the transmission of information between the intermediate means and the module and vice versa, the intermediate means being equipped with a transmitter-receiver for communicating with the transmitting means and the transmitting means comprising a transmitter-receiver for communicating with the intermediate means, characterized in that the intermediate means consist of a card having the shape and the dimensions of a smart card but without a processing chip and being equipped with a connector compatible with the reader.

6. A system as claimed in claim 5, characterized in that the conduction zones of the module and of the transmitting means are insulated electrically from any contact with the physical outside of the system.

7. A system as claimed in either one of claims 5 or 6, characterized in that the module comprises an integrated supply means.

FIG_1

FIG_2

# FIG_3

vue de dessus

vue de dessous

vue en coupe

coupe A A'

# FIG_4